# EUROPEAN PATENT APPLICATION

(11) **EP 4 394 898 A1**
(43) Date of publication of application: **03.07.2024**
(21) Application number: 21881789.8
(22) Date of filing: 16.09.2021
(51) Int. Cl.: H01L 31/055

(54) **LIGHT-EMITTING SOLAR ENERGY COLLECTION DEVICE AND MANUFACTURING METHOD THEREFOR**

(71) Applicant: Xingyu Technology (Shanghai) Co., Ltd., Shanghai 200241 (CN); MPW Technologies International Pte. Ltd., Singapore 069920 (SG)
(72) Inventor: PENG, Zhen, Shanghai 201615 (CN); WANG, Jusong, Beijing 100161 (CN)
(74) Representative: Bjerkén Hynell KB
(86) International application number: PCT/CN2021/118804
(87) International publication number: WO 2022/083370

(57) **Abstract**

A light-emitting solar energy collection device and a manufacturing method therefor. The light-emitting solar energy collection device comprises: a transparent substrate (100); at least one solar cell (200), disposed on a portion of a region on one side of the transparent substrate (100); a photoluminescence layer (300), disposed on the side of the transparent substrate (100) provided with the solar cell, and covering the solar cell, the photoluminescence layer (300) being in contact with at least a portion of the solar cells (200) in order to secure the solar cells on the transparent substrate (100). In the light-emitting solar energy collection device and the manufacturing method therefor according to the embodiments of the present invention, since the solar cells (200) may be at least partially fixed by the photoluminescence layer (300) itself, the use of a bonding layer (400) for fixing may therefore be reduced or omitted, thereby being able to simplify processing, save materials, and reduce costs.

## Description

### TECHNICAL FIELD

Embodiments of the present disclosure relate to a light-emitting solar energy collection device and a manufacturing method therefor.

### BACKGROUND

The application of photovoltaic technology in agriculture can achieve efficient use of both agricultural land and solar energy, greatly expanding photovoltaic power generation on open land without using precious resources on fertile farmland. Optimizing the output of photovoltaic power generation and photosynthesis through targeted light management can create regional value and promote rural development. Therefore, agricultural photovoltaic projects are promising technological developments. Improving the efficiency of both photovoltaic power generation and the use of light for crop growth has always been one of the goals pursued by such technologies.

### SUMMARY

According to at least one embodiment of the present disclosure, a light-emitting solar energy collection device is provided, including: a transparent substrate; at least one solar cell, disposed on a portion of a region on a side of the transparent substrate; and a photoluminescent layer, disposed on the side of the transparent substrate provided with the solar cell, and covering the solar cell, wherein the photoluminescent layer is in contact with at least a portion of the solar cell to secure the solar cell on the transparent substrate.

In the light-emitting solar energy collection device according to at least one embodiment of the present disclosure, the photoluminescent layer includes a transparent matrix material and photoluminescent particles mixed in the transparent matrix material.

In the light-emitting solar energy collection device according to at least one embodiment of the present disclosure, the transparent matrix material includes a transparent adhesive.

In the light-emitting solar energy collection device according to at least one embodiment of the present disclosure, an entire surface of the photoluminescent layer facing the transparent substrate is in contact with the transparent substrate, and the solar cell is completely embedded in the photoluminescent layer.

In the light-emitting solar energy collection device according to at least one embodiment of the present disclosure, a sum of a thickness of the transparent substrate and a thickness of the photoluminescent layer is greater than a thickness of the solar cell by 300 micrometers or more.

In the light-emitting solar energy collection device according to at least one embodiment of the present disclosure, the solar cell is bonded to the transparent substrate through a transparent bonding layer, a surface of the solar cell facing away from the transparent substrate is embedded in the photoluminescent layer, and except for a region where the solar cell is disposed, the photoluminescent layer is in direct contact with the transparent bonding layer.

In the light-emitting solar energy collection device according to at least one embodiment of the present disclosure, at least a portion of a side surface of the solar cell is in contact with the photoluminescent layer.

In the light-emitting solar energy collection device according to at least one embodiment of the present disclosure, the transparent bonding layer has a thickness of 200 micrometers or less.

In the light-emitting solar energy collection device according to at least one embodiment of the present disclosure, the photoluminescent layer is in contact with a surface of the solar cell facing away from the transparent substrate and a side surface of the solar cell; and except for a region where the solar cell is disposed, the photoluminescent layer is in direct contact with the transparent substrate.

The light-emitting solar energy collection device according to at least one embodiment of the present disclosure further includes a transparent protective layer located on a side of the photoluminescent layer facing away from the transparent substrate.

In the light-emitting solar energy collection device according to at least one embodiment of the present disclosure, a light extraction structure is disposed on a surface of the photoluminescent layer facing away from the transparent substrate, and configured to extract light of a predetermined wave band and emit the light in a direction within a predetermined angle range with respect to a normal direction of the transparent substrate.

In the light-emitting solar energy collection device according to at least one embodiment of the present disclosure, the predetermined wave band includes a red light band, and the predetermined angle range is less than 30 degrees.

In the light-emitting solar energy collection device according to at least one embodiment of the present disclosure, the photoluminescent layer is configured to have an absorption rate of 70% or lower for blue light and an absorption rate of 50% or higher for green light, and convert absorbed light into red light.

According to at least one embodiment of the present disclosure, a manufacturing method for a light-emitting solar energy collection device is provided, including: preparing a transparent substrate and at least one solar cell; mixing a transparent matrix material and photoluminescent particles to form a photoluminescent material; and disposing the photoluminescent material and the at least one solar cell on the transparent substrate such that the photoluminescent material forms a photoluminescent layer, where the photoluminescent layer is in contact with at least a portion of the solar cell to secure the solar cell on the transparent substrate.

In the manufacturing method for a light-emitting solar energy collection device according to at least one embodiment of the present disclosure, the transparent matrix material is a curable transparent gel, and the photoluminescent particles are dispersed in the transparent gel.

In the manufacturing method for a light-emitting solar energy collection device according to at least one embodiment of the present disclosure, before the transparent gel is cured, the at least one solar cell is mixed into the photoluminescent material. Disposing the photoluminescent material and the at least one solar cell on the transparent substrate includes: applying the photoluminescent material mixed with the at least one solar cell to the transparent substrate.

In the manufacturing method for a light-emitting solar energy collection device according to at least one embodiment of the present disclosure, disposing the photoluminescent material and the at least one solar cell on the transparent substrate includes: placing the at least one solar cell on the transparent substrate and then applying the photoluminescent material on a side of the transparent substrate where the at least one solar cell is disposed.

In the manufacturing method for a light-emitting solar energy collection device according to at least one embodiment of the present disclosure, before the at least one solar cell is placed on the transparent substrate, a transparent bonding layer is applied to the transparent substrate to preliminarily secure the at least one solar cell subsequently placed.

In the manufacturing method for a light-emitting solar energy collection device according to at least one embodiment of the present disclosure, the transparent bonding layer has a thickness of 200 micrometers or less.

In the manufacturing method for a light-emitting solar energy collection device according to at least one embodiment of the present disclosure, after the photoluminescent material and the at least one solar cell are disposed on the transparent substrate, the transparent gel is cured to form the photoluminescent layer.

In the light-emitting solar energy collection device and the manufacturing method therefor according to the embodiments of the present disclosure, since the solar cell can be partially secured by the photoluminescent layer, the use of a bonding layer for fixation can be reduced or omitted, thereby simplifying the process, saving materials, and reducing costs.

### BRIEF DESCRIPTION OF THE DRAWINGS

In order to more clearly illustrate the technical solutions in the embodiments of the present disclosure, accompanying drawings related to the embodiments will be briefly described below. Obviously, the accompanying drawings in the following description are only some embodiments of the present disclosure rather than limitations on the present disclosure.
FIG. 1 is a schematic cross-sectional view of a solar energy collection device;
FIG. 2 is a schematic cross-sectional view of a light-emitting solar energy collection device according to some embodiments of the present disclosure;
FIG. 3 is a schematic cross-sectional view of a light-emitting solar energy collection device according to other embodiments of the present disclosure;
FIG. 4 is a schematic cross-sectional view of a light-emitting solar energy collection device according to other embodiments of the present disclosure;
FIG. 5 is a schematic cross-sectional view of a light-emitting solar energy collection device according to other embodiments of the present disclosure;
FIG. 6 is a schematic cross-sectional view of a light-emitting solar energy collection device according to other embodiments of the present disclosure; and
FIG. 7 is a flowchart of a manufacturing method for a light-emitting solar energy collection device according to some embodiments of the present disclosure.

### DETAILED DESCRIPTION OF THE EMBODIMENTS

To make the objectives, technical solutions, and advantages of the embodiments of the present disclosure clearer, the technical solutions in the embodiments of the present disclosure are clearly and completely described below with reference to the accompanying drawings in the embodiments of the present disclosure. Apparently, the described examples are a part of, but not all of, the examples of the present disclosure. Based on the described examples of the present disclosure, all other examples obtained by those of ordinary skill in the art without creative efforts shall fall within the protection scope of the present disclosure.

Unless otherwise defined, the technical or scientific terms used herein are as they are usually understood by those skilled in the art to which the present disclosure pertains. "First", "second" and similar words used in this specification and in the claims do not denote any order, quantity or importance, but are merely intended to distinguish between different constituents. Similarly, the terms "one", "a", and similar words are not meant to be limiting, but rather denote the presence of at least one.

The wavelength of solar radiation is roughly in the range of 0.2 to 3 µm, covering the ultraviolet, visible light, and near-infrared regions. After absorption by the atmosphere, scattering attenuation and redirection, and other effects, total solar radiation reaching the Earth's surface is composed of direct radiation (accounting for about 90% of total energy) and scattered radiation (also known as sky radiation), and the intensity and distribution of radiation have also changed. Among the solar radiation spectrum, the visible light region allows for active photosynthesis of crops. Visible light is the most crucial part for plants to conduct photosynthesis. Within the visible light region, blue light and red light, especially red light, are the most critical parts in the solar spectrum because chlorophyll in plants efficiently absorbs the parts of the light, while green light is less easily absorbed. The infrared light region can be further divided into near-infrared and far-infrared. Near-infrared light (with a wavelength ranging from 780 to 3,000 nm) is essentially useless for plants as it only generates thermal energy. Far-infrared light has a wavelength of 3,000 to 50,000 nm, and this part of the radiation is not directly from sunlight but is generated by molecules with thermal energy, which easily dissipates at night.

Plants are most sensitive to the spectral band ranging from 400 to 700 nm, which is commonly referred to as the photosynthetically active radiation (PAR) region. Approximately 45% of solar energy lies within this spectral range. Moreover, plants are most sensitive to the red light spectrum and less sensitive to green light. Therefore, the combination of technologies such as photovoltaic power generation and spectral conversion can achieve overall effective utilization of solar energy.

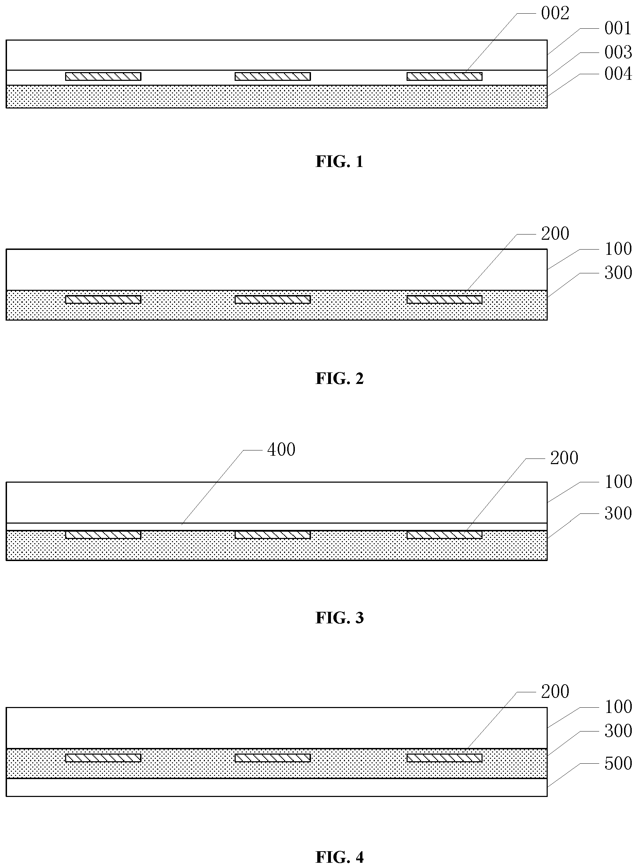

FIG. 1 shows a solar energy collection device for agricultural production. As shown in FIG. 1, the solar energy collection device includes a transparent substrate 001, solar cells 002 formed on the transparent substrate, and a bonding layer 003 for adhering the solar cells 002 to the transparent substrate 001. Additionally, a photoluminescent layer 004 is disposed on the side of the solar cells away from the transparent substrate. The solar cells 002 can absorb part of blue or green light for photovoltaic conversion for electricity generation. Light that passes through gaps between the solar cells 002 or does not pass through the solar cells 002 enters the photoluminescent layer 004. In the photoluminescent layer 004, blue and/or green light can be converted into red light needed for crops, to increase the ratio of red light, thereby promoting crop growth. In the solar energy collection device, the photoluminescent layer 004 is generally a flexible sheet-like structure, and the bonding layer 003 serves to secure the solar cells 002 on the transparent substrate 001 and bond the sheet-like photoluminescent layer 004 to the transparent substrate. In this structure, it is generally required to avoid contact between the solar cells and the photoluminescent layer.

However, the manufacturing process of the solar energy collection device requires at least steps of laying the solar cells on the transparent substrate, coating the bonding layer on the transparent substrate, and bonding the sheet-like photoluminescent layer to the transparent substrate, leading to a complex process, which impedes reduction of production costs. Furthermore, in such solar cells, since the solar cells need to be fully immersed in the bonding layer, a thicker bonding layer is required. In addition to increasing the thickness and weight of the entire product, the bonding layer, although it can be made of materials with higher transmittance, still absorbs a small amount of light, thus affecting the overall transmittance of the product.

According to some embodiments of the present disclosure, a light-emitting solar energy collection device is provided, including: a transparent substrate; at least one solar cell, disposed on a portion of a region on a side of the transparent substrate; and a photoluminescent layer, disposed on the side of the transparent substrate provided with the solar cell, wherein the photoluminescent layer covers the solar cell, and the photoluminescent layer is in contact with at least a portion of the solar cell to secure the solar cell on the transparent substrate. In the light-emitting solar energy collection device according to some embodiments of the present disclosure, the photoluminescent layer is in contact with at least a portion of the solar cell to secure the solar cell on the transparent substrate, thereby reducing the use of a bonding layer or even completely avoiding the use of a bonding layer. This can decrease the thickness of the entire product and increase the transmittance, simplify the manufacturing process of the product, and reduce material and process costs.

In the following text, the light-emitting solar energy collection device according to some embodiments of the present disclosure will be described in detail with reference to the accompanying drawings.

FIG. 2 is a schematic cross-sectional view of a light-emitting solar energy collection device according to some embodiments of the present disclosure. As shown in FIG. 2, the light-emitting solar energy collection device includes a transparent substrate 100, as well as solar cells 200 and a photoluminescent layer 300 that are disposed on the transparent substrate. The photoluminescent layer 300 is in contact with at least a portion of the solar cells 200. In other words, the solar cells 200 are secured on the transparent substrate 200 through the photoluminescent layer.

For example, as shown in FIG. 2, in this embodiment, the solar cells 200 are fully immersed (embedded) in the photoluminescent layer 300, and all surfaces of the solar cells 200 are in contact with the photoluminescent layer 300.

It should be noted that FIG. 2 is merely a schematic cross-sectional view according to some embodiments of the present disclosure. For example, FIG. 2 only shows three solar cells arranged in sequence, but this quantity is merely exemplary. In the light-emitting solar energy collection device according to the embodiments of the present disclosure, fewer or more solar cells can be arranged at the location as shown in the cross-sectional view. There is no particular limitation on the number of solar cells in the light-emitting solar energy collection device according to the embodiments of the present disclosure, and it can be appropriately determined based on the entire planar area of the light-emitting solar energy collection device and the spacing requirements between adjacent solar cells. Additionally, the position of the cross section taken in FIG. 2 is not specifically defined but arbitrarily chosen to show the positional relationship among the transparent substrate, solar cells, and photoluminescent layer at the sectional view, provided that the cross section passes through the solar cells. Therefore, it is evident that in the plan view, multiple solar cells of the light-emitting solar energy collection device according to the embodiments of the present disclosure can be arranged in a two-dimensional manner in the plane direction and spaced apart from each other. There is no particular limitation on the two-dimensional arrangement of the multiple solar cells in the light-emitting solar cells according to the embodiments of the present disclosure. Furthermore, the photoluminescent layer 300 can cover the entire transparent substrate 100 or only a portion of the transparent substrate 100. In some embodiments, the photoluminescent layer 300 can cover all the solar cells arranged on the transparent substrate 100. This explanation applies to the cross-sectional view of any embodiments described below. Therefore, this explanation will not be repeated in the introduction of the subsequent embodiments of the light-emitting solar energy collection device.

For example, in the light-emitting solar energy collection device according to the embodiments of the present disclosure, the transparent substrate 100 can be any suitable transparent substrate, such as a glass substrate, a polymethyl methacrylate (PMMA) substrate, or a polycarbonate substrate. Here, "transparent" means that light will not be absorbed during propagation, although this is an ideal state, and light may be absorbed to a small extent. In the embodiments of the present disclosure, there is no specific requirement for the transmittance of the transparent substrate. Definitely, higher transmittance is advantageous for the efficient utilization of light. For example, in some examples, the visible light transmittance of the transparent substrate can be 80% or higher. Additionally, there are no specific limitations on the material, thickness, etc. of the transparent substrate according to the present disclosure, and appropriate materials and thicknesses can be selected based on actual needs. It should be noted that the explanation regarding the meaning of "transparent" in the transparent substrate also applies to the meaning of "transparent" in other transparent components in the embodiments of the present disclosure.

In some examples, the solar cells in the light-emitting solar energy collection device can be organic solar cells or inorganic solar cells. For example, the absorption spectrum bands of the solar cells can be in the blue, ultraviolet, or infrared spectrum bands. If light in these spectrum bands is absorbed, it is possible to utilize light beyond the spectrum required for photosynthesis in crops, thereby effectively utilizing various light in the entire solar spectrum. However, the embodiments of the present disclosure are not limited to this. The absorption wave band range of the solar cell, the specific structure of the solar cell, and the basic materials of the solar cell can be selected according to actual needs. For example, the solar cell can have a sheet-like structure. For instance, each solar cell can have a rectangular or square sheet-like structure, but the embodiments of the present disclosure are not limited thereto. For example, the solar cells in the embodiments of the present disclosure can be silicon-based semiconductor solar cells, gallium arsenide-based semiconductor solar cells, or the like.

In some examples, the photoluminescent layer can be a single layer of optically transparent adhesive mixed with luminescent dyes capable of absorbing blue and/or green light to generate red light. This material can be easily applied to the surface of transparent waveguides (such as the transparent substrate mentioned above). For example, in the case of using this material, the solar cells can be immersed in a gel already mixed with luminescent dyes, and then the transparent adhesive can be cured to bond the solar cells to the transparent substrate. It should be noted that, in some embodiments of the present disclosure, the matrix material of the photoluminescent layer can be an adhesive capable of photo-curing. During the preparation process, the solar cells can be immersed in the photoluminescent layer before curing, and then coated onto the transparent substrate together. The manufacturing method for the light-emitting solar energy collection device of the present disclosure will be described in detail later. There is no particular limitation on the specific material of the transparent adhesive, as long as it can be mixed with luminescent dyes in liquid form and can be cured, and the light transmittance of the cured transparent adhesive meets the light transmittance requirements. However, in order to reduce the light loss induced by the transparent adhesive itself, it is preferable to use materials with high light transmittance. For example, the transparent adhesive can be an optical clear resin (OCR). OCR is a liquid optical adhesive that is colorless and transparent after curing, with a light transmittance of over 98%, and features such as low curing shrinkage and yellowing resistance. However, the embodiments of the present disclosure are not limited thereto.

As for the luminescent dyes, suitable dyes that absorb/emit suitable wavelengths can be selected according to actual needs, and there are no particular restrictions in the embodiments of the present disclosure. For example, suitable luminescent dyes can be selected to ensure that the absorption rate of the photoluminescent layer for blue light is 70% or lower, the absorption rate for green light is 50% or higher, and the absorbed light is converted into red light and reflected.

In the embodiments of the present disclosure, the solar cells are directly immersed in the light conversion material, and are secured directly to the transparent substrate by the light conversion material. Therefore, the manufacturing process of coating the bonding layer is omitted, thereby saving materials and greatly reducing costs.

For the light-emitting solar energy collection device according to the embodiments of the present disclosure, after the sunlight passes through the transparent substrate, a portion of the sunlight is incident on the solar cells. The solar cells absorb corresponding light according to spectral band characteristics and reflect or transmit other light. A portion of the light passes through the gaps between the solar cells and enters the photoluminescent layer. The optical dyes in the photoluminescent layer absorb a portion of blue or green light, convert it into red light, and emit the red light from the photoluminescent layer. Therefore, the red light component projected onto the side of the photoluminescent layer away from the transparent substrate is increased, and red light is the main light for photosynthesis of plants. Therefore, the light-emitting solar energy collection device according to the embodiments of the present disclosure can effectively utilize solar radiation, with some light used for photovoltaic power generation and some light used for illuminating plants. Moreover, the red light component in the light used for illuminating plants is increased due to the action of the photoluminescent layer. The electricity generated by photovoltaic power generation can be used for nighttime lighting, powering other components, etc. Furthermore, since the light-emitting solar energy collection device according to the embodiments of the present disclosure eliminates the bonding layer used separately for bonding solar cells and uses the photoluminescent layer to directly secure the solar cells, light losses caused by the relatively thick bonding layer is avoided.

Furthermore, as shown in FIG. 2, the solar cell 200 is fully immersed in the photoluminescent layer 300, but the solar cell is located in the part of the photoluminescent layer 300 close to the transparent substrate. In other words, a portion of the photoluminescent layer material is located between the solar cell 200 and the transparent substrate 100. Although a portion of the photoluminescent layer is located between the solar cell and the transparent substrate, and part of blue and green light from the sunlight passing through the transparent substrate is absorbed by this portion of the photoluminescent layer, the absorbed blue or green light also generates red light at the same time. Therefore, it does not affect or only minimally affects the absorption of light by the solar cell. In some examples, the thickness of the portion of the photoluminescent layer located between the solar cell and the transparent substrate is less than half the thickness of the overall photoluminescent layer. In some examples, the thickness of the portion of the photoluminescent layer located between the solar cell and the transparent substrate is less than one-third of the thickness of the overall photoluminescent layer. In other examples, the thickness of the portion of the photoluminescent layer located between the solar cell and the transparent substrate is less than one-fourth of the thickness of the overall photoluminescent layer. The smaller the thickness of the portion of the photoluminescent layer located between the solar cell and the transparent substrate, the less impact it has on the photovoltaic conversion by the solar cell. However, the above proportion relationship is merely exemplary, and the light-emitting solar energy collection device according to the embodiments of the present disclosure is not limited thereto.

For example, refractive indices of the transparent substrate and the photoluminescent layer are approximately the same, and when stacked together, they act as an optical waveguide, allowing light to propagate therein by total reflection. Therefore, after entering the transparent substrate and the photoluminescent layer, light can propagate by total reflection in the transparent substrate and the photoluminescent layer. During the total reflection propagation, the absorption rate of light by the solar cell and the photoluminescent layer is further increased. In order to better facilitate total reflection propagation in the photoluminescent layer, a total thickness of the transparent substrate and the photoluminescent layer is, for example, greater than a thickness of the solar cell by 300 micrometers or more.

Additionally, in the light-emitting solar energy collection device according to the embodiments of the present disclosure, the transparent substrate can also provide support and protection, that is, supporting and protecting the solar cells and the photoluminescent layer located on the transparent substrate.

FIG. 3 is a schematic cross-sectional view of a light-emitting solar energy collection device according to another embodiment of the present disclosure. As shown in FIG. 3, in this light-emitting solar cell, a bonding layer 400 is provided on the transparent substrate 100, and the solar cells 200 are disposed on the bonding layer 400 and covered by the photoluminescent layer 300. In this embodiment, a portion of the surface of the solar cell is in contact with the photoluminescent layer 300. The bonding layer 400 and the photoluminescent layer 300 together secure the solar cell to the transparent substrate 100. Compared with the embodiment shown in FIG. 2, the light-emitting solar energy collection device of this embodiment adds a bonding layer 400 located between the solar cell and the transparent substrate. The bonding layer 400 is used, for example, to preliminarily secure the solar cell during the preparation process and prevent air gaps between the solar cell 200 and the transparent substrate 100. If there are air gaps between the solar cell and the transparent substrate, reflective interfaces may occur, affecting the entry of light from the transparent substrate into the solar cell and thus reducing the efficiency of light utilization. The bonding layer 400 can prevent the occurrence of air gaps.

For example, the bonding layer 400 only needs to preliminarily secure the solar cell during the manufacturing process, which is unlike the example shown in FIG. 1 where the solar cell needs to be completely immersed. Therefore, in the embodiment shown in FIG. 3, the bonding layer 400 can be designed to be relatively thin. For instance, the thickness of the bonding layer 400 can be 200 micrometers or less.

For example, the material of the bonding layer 400 is not specifically limited and can be a transparent adhesive capable of curing. For example, the material can be the same transparent adhesive used as the matrix material for the photoluminescent layer mentioned above. For instance, it can be an optical clear resin (OCR). Therefore, the material of the bonding layer can be the same as or different from the matrix material in the photoluminescent layer.

For instance, as shown in FIG. 3, the surface of the solar cell 200 facing away from the transparent substrate 100 is embedded in the photoluminescent layer 300, and except for the region where the solar cell 200 is disposed, the photoluminescent layer 300 is in direct contact with the transparent bonding layer. For example, as shown in FIG. 3, among the two main surfaces of the solar cell, the main surface facing the transparent substrate is in contact with the bonding layer 400, while the main surface facing away from the transparent substrate 100 is in contact with the photoluminescent layer. Additionally, FIG. 3 shows that the side surface of the solar cell 200 (the surface connecting the two main surfaces of the solar cell) is also immersed in the photoluminescent layer 300. However, the embodiments of the present disclosure are not limited thereto. The side surface of the solar cell 200 can be immersed in the bonding layer 400, or partially immersed in the bonding layer 400 and partially in the photoluminescent layer 300.

The transparent substrate 100, solar cell 200, and photoluminescent layer 300 in the embodiment shown in FIG. 3 can be implemented with corresponding components as shown in FIG. 2. Therefore, the explanation for these components will not be repeated.

Additionally, although the embodiment in FIG. 3 includes a transparent bonding layer to preliminarily secure the subsequently applied solar cell and prevent air gaps between the solar cell and the transparent substrate, the transparent bonding layer may not be included in some embodiments of the present disclosure. In other words, the transparent bonding layer 400 may be removed from FIG. 3. In this case, the photoluminescent layer 300 is in direct contact with both the surface of the solar cell 200 facing away from the transparent substrate 100 and the side surface of the solar cell 200, and except for the region where the solar cell 200 is disposed, the photoluminescent layer 300 is directly in contact with the transparent substrate 100.

FIG. 4 is a schematic cross-sectional view of a light-emitting solar energy collection device according to other embodiments of the present disclosure. As shown in FIG. 4, based on the light-emitting solar energy cell collection device shown in FIG. 2, a transparent protective layer 500 is further provided on the side of the photoluminescent layer 200 away from the transparent substrate. The material of the transparent protective layer 500 can be the same as or different from the material of the transparent substrate 100, which is not particularly limited in this embodiment of the present disclosure. For example, the matrix material of the photoluminescent layer 300 is an organic material that is prone to friction damage even after curing, while the transparent protective layer 500 can serve to protect the photoluminescent layer.

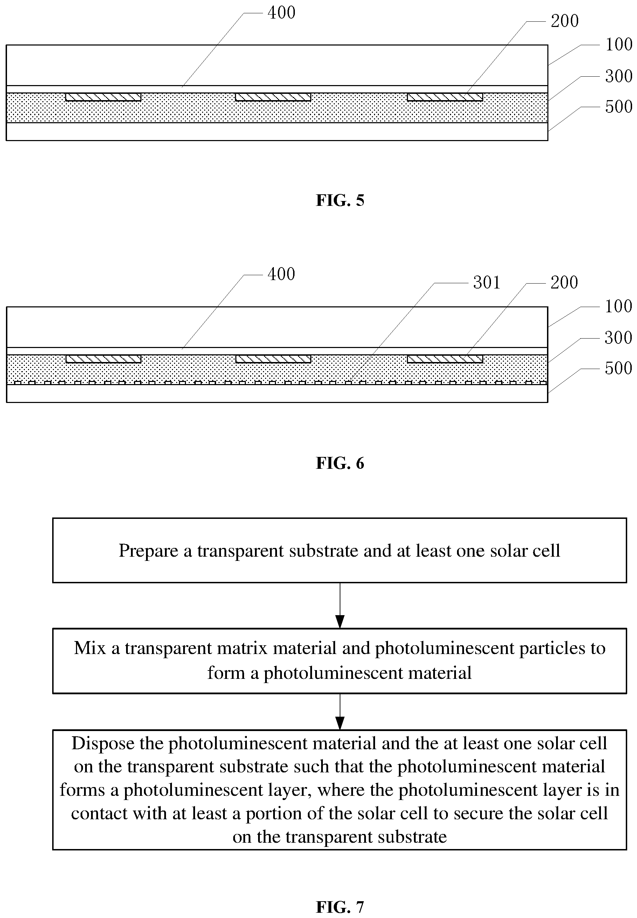

FIG. 5 is a schematic cross-sectional view of a light-emitting solar energy collection device according to another embodiment of the present disclosure. As shown in FIG. 5, based on the light-emitting solar energy cell collection device shown in FIG. 3, a transparent protective layer 500 is further provided on the side of the photoluminescent layer 200 away from the transparent substrate. The material of the transparent protective layer 500 can be the same as or different from the material of the transparent substrate 100, which is not particularly limited in this embodiment of the present disclosure. For example, the matrix material of the photoluminescent layer 300 is an organic material that is prone to friction damage even after curing, while the transparent protective layer 500 can serve to protect the photoluminescent layer.

FIG. 6 is a schematic cross-sectional view of a light-emitting solar energy collection device according to another embodiment of the present disclosure. In comparison with the embodiment of the light-emitting solar energy collection device shown in FIG. 4, the light-emitting solar energy collection device in the embodiment shown in FIG. 6 includes a light extraction structure 301 disposed on the surface of the photoluminescent layer 300 away from the transparent substrate 100. For example, the light extraction structure 301 can be a grating structure, which may consist of alternating grooves and protrusions arranged on the surface of the photoluminescent layer. The period or other parameters or parameter combinations of the grating structure can be configured such that light of a particular wavelength band is emitted from the photoluminescent layer within a specific angle range. For instance, the period or other parameters or parameter combinations of the grating structure can be configured such that red light is emitted within an angle range of less than 30 degrees with respect to the normal of the transparent substrate. The grating structure can enhance the extraction efficiency of light in specific wave bands (such as red light). For example, the grating structure can be formed on the surface of the photoluminescent layer through imprinting, but the embodiments of the present disclosure are not limited thereto.

Some embodiments of the present disclosure further provide a manufacturing method for a light-emitting solar energy collection device. As shown in FIG. 7, the method includes: preparing a transparent substrate and at least one solar cell; mixing a transparent matrix material and photoluminescent particles to form a photoluminescent material; and disposing the photoluminescent material and the at least one solar cell on the transparent substrate such that the photoluminescent material forms a photoluminescent layer, wherein the photoluminescent layer is in contact with at least a portion of the solar cell to secure the solar cell on the transparent substrate.

For example, in this manufacturing method, the transparent substrate, solar cell, and photoluminescent layer can correspond to the transparent substrate 100, solar cell 200, and photoluminescent layer 300 in the above embodiments. The description for these components will not be repeated.

In some examples, the transparent matrix material is a curable transparent gel, and the photoluminescent particles are dispersed in the transparent gel.

For example, before the transparent gel is cured, the at least one solar cell is mixed into the photoluminescent material. Disposing the photoluminescent material and the at least one solar cell on the transparent substrate includes: applying the photoluminescent material mixed with the at least one solar cell to the transparent substrate. For instance, the structure formed by this method can be the structure of the light-emitting solar energy collection device shown in FIG. 2, where the solar cell is immersed in the photoluminescent layer, and a portion of the photoluminescent layer is retained between the solar cell and the transparent substrate. With this method, the process of separately coating the bonding layer (such as the bonding layer coating process when manufacturing the structure shown in FIG. 1) is omitted, thereby simplifying the process, saving materials, reducing the product thickness, and improving the light transmittance.

In some examples, the at least one solar cell may be first placed on the transparent substrate, and then the above-mentioned photoluminescent material is coated onto the side of the transparent substrate where the solar cell is located. After the photoluminescent material is cured to form the photoluminescent layer, the photoluminescent layer secures the solar cell to the transparent substrate. In this manufacturing method, after the solar cell is placed on the transparent substrate, there may be air gaps between the solar cell and the transparent substrate. After the photoluminescent material is coated onto the transparent substrate, a part of liquid photoluminescent material may penetrate into the air gaps, but a part of air gaps may also be retained. Air gaps may form reflective interfaces, affecting the effective utilization of light.

In some examples, before the at least one solar cell is placed on the transparent substrate, a bonding layer is applied to the transparent substrate to preliminarily secure the at least one solar cell subsequently placed, and then the solar cell is disposed on the bonding layer. The bonding layer can prevent the formation of the above-mentioned air gaps between the solar cell and the transparent substrate. Additionally, the bonding layer here is only used for preliminarily securing the solar cell, while the solar cell is completely secured by the subsequently formed photoluminescent layer. Therefore, the required thickness of the bonding layer is smaller than that in the embodiment shown in FIG. 1, which can also reduce the product thickness and increase the light transmittance.

In the above example, regardless of the method used to apply the photoluminescent material to the transparent substrate, it is necessary to cure the photoluminescent material to form the photoluminescent layer. The method of curing the photoluminescent material depends on the properties of the transparent material. For example, UV curing or thermal curing may be adopted, which is not specifically limited in the embodiments of the present disclosure.

The light-emitting solar energy collection device according to the embodiments of the present disclosure can be applied in the technical field of agriculture. For example, the light-emitting solar energy collection device can be applied to agricultural greenhouses. For example, the light-emitting solar energy collection device serves as a light-transmitting window for the agricultural greenhouse, thus forming an efficient ecological photovoltaic agricultural greenhouse. For instance, when the light-emitting solar energy collection device of the present disclosure serves as a light-transmitting window for the agricultural greenhouse, the transparent substrate can be oriented towards the outside, i.e., towards the sun. This type of agricultural greenhouse does not occupy additional arable land to achieve the added value of the original land, and combines ecological agriculture with green power generation, thereby maximizing resource utilization. While achieving the economic benefits of efficient agriculture and green power generation, it also realizes the social benefits of energy conservation and emission reduction. Specifically, the light-emitting solar energy collection device in the embodiments of the present disclosure, as described above, not only simplifies processes and saves materials, but also further improves the utilization efficiency of sunlight. Therefore, when used in photovoltaic agricultural greenhouses, the device may further enhance the economic benefits of the agricultural greenhouses.

The above only describes the application scenarios of the light-emitting solar energy collection device in the embodiments of the present disclosure by using agricultural greenhouses as an example. However, the embodiments of the present disclosure are not limited thereto. For example, by adjusting the absorption spectrum bands of solar cells, the absorption and emission wavelength ranges of the photoluminescent layer, and so on, it can be applied to other suitable scenarios, and can also simplify processes, save materials, and further improve the utilization efficiency of sunlight.

The features of the same or different embodiments of the present disclosure can be combined with each other in a non-conflicting manner. For example, the grating structure disposed on the surface of the photoluminescent layer 300 facing away from the transparent substrate 100 as shown in FIG. 6 can be applied to the photoluminescent layer of the light-emitting solar energy collection device in any embodiment shown in FIG. 2 to FIG. 5, and can also achieve the effect of efficiently extracting light with a specific wavelength.

It should be noted that the schematic cross-sectional views in the accompanying drawings of the present disclosure are not drawn to scale. The proportional relationship of various components in the drawings should not limit the design of components of the light-emitting solar energy collection device according to the embodiments of the present disclosure. In addition, to illustrate the characteristics of the embodiments of the present disclosure, only essential components are emphasized or described. The light-emitting solar energy collection device according to the embodiments of the present disclosure may include any other suitable additional components. For example, the leads for extracting the electrical energy generated through photovoltaic power generation using the solar cells can be arranged on the transparent substrate. The width, length, and material of the leads can adopt designs known in the art, and are not particularly limited in the embodiments of the present disclosure. For example, various optical functional film layers, such as an anti-reflection layer, can also be coated on the transparent substrate; optical functional film layers or optical microstructures can also be coated or formed on the transparent protective layer. The light-emitting solar energy collection device according to the embodiments of the present disclosure has no particular limitations on this.

Described above are only exemplary embodiments of the present disclosure, which are not intended to limit the protection scope of the present disclosure. The protection scope of the present disclosure is defined by the appended claims.

## Claims

1. A light-emitting solar energy collection device, comprising:
a transparent substrate (100);
at least one solar cell (200), disposed on a portion of a region on a side of the transparent substrate (100); and
a photoluminescent layer (300), disposed on the side of the transparent substrate (100) provided with the solar cell (200), and covering the solar cell (200),
wherein the photoluminescent layer (300) is in contact with at least a portion of the solar cell (200) to secure the solar cell (200) on the transparent substrate (100).

2. The light-emitting solar energy collection device according to claim 1, wherein
the photoluminescent layer (300) comprises a transparent matrix material and photoluminescent particles mixed in the transparent matrix material, wherein the transparent matrix material comprises a transparent adhesive.

3. The light-emitting solar energy collection device according to claim 1 or claim 2, wherein
an entire surface of the photoluminescent layer (300) facing the transparent substrate (100) is in contact with the transparent substrate (100), and the solar cell (200) is completely embedded in the photoluminescent layer (300), wherein a sum of a thickness of the transparent substrate (100) and a thickness of the photoluminescent layer (300) is greater than a thickness of the solar cell (200) by 300 micrometers or more.

4. The light-emitting solar energy collection device according to claim 1 or claim 2, wherein
the solar cell (200) is bonded to the transparent substrate (100) through a transparent bonding layer (400), a surface of the solar cell (200) facing away from the transparent substrate (100) is embedded in the photoluminescent layer (300), and except for a region where the solar cell (200) is disposed, the photoluminescent layer (300) is in direct contact with the transparent bonding layer (400), wherein the transparent bonding layer (400) has a thickness of 200 micrometers or less.

5. The light-emitting solar energy collection device according to claim 4, wherein
at least a portion of a side surface of the solar cell (200) is in contact with the photoluminescent layer (300).

6. The light-emitting solar energy collection device according to claim 1 or claim 2, wherein
the photoluminescent layer (300) is in contact with a surface of the solar cell (200) facing away from the transparent substrate (100) and a side surface of the solar cell (200); and except for a region where the solar cell (200) is disposed, the photoluminescent layer (300) is in direct contact with the transparent substrate (100).

7. The light-emitting solar energy collection device according to any one of claims 1 to 6, further comprising:
a transparent protective layer (500) located on a side of the photoluminescent layer (300) facing away from the transparent substrate (100).

8. The light-emitting solar energy collection device according to any one of claims 1 to 7, wherein
a light extraction structure (301) is disposed on a surface of the photoluminescent layer (300) facing away from the transparent substrate (100), and configured to extract light of a predetermined wave band and emit the light in a direction within a predetermined angle range with respect to a normal direction of the transparent substrate (100), wherein the predetermined wave band comprises a red light band, and the predetermined angle range is less than 30 degrees.

9. The light-emitting solar energy collection device according to any one of claims 1 to 8, wherein
the photoluminescent layer (300) is configured to have an absorption rate of 70% or lower for blue light and an absorption rate of 50% or higher for green light, and convert absorbed light into red light.

10. A manufacturing method for a light-emitting solar energy collection device, comprising:
preparing a transparent substrate (100) and at least one solar cell (200);
mixing a transparent matrix material and photoluminescent particles to form a photoluminescent material; and
disposing the photoluminescent material and the at least one solar cell (200) on the transparent substrate (100) such that the photoluminescent material forms a photoluminescent layer (300), wherein the photoluminescent layer (300) is in contact with at least a portion of the solar cell (200) to secure the solar cell (200) on the transparent substrate (100).

11. The method according to claim 10, wherein
the transparent matrix material is a curable transparent gel, and the photoluminescent particles are dispersed in the transparent gel.

12. The method according to claim 11, wherein
before the transparent gel is cured, the at least one solar cell (200) is mixed into the photoluminescent material; and
disposing the photoluminescent material and the at least one solar cell (200) on the transparent substrate (100) comprises: applying the photoluminescent material mixed with the at least one solar cell to the transparent substrate (100).

13. The method according to claim 11, wherein disposing the photoluminescent material and the at least one solar cell (200) on the transparent substrate (100) comprises: placing the at least one solar cell on the transparent substrate (100), and then applying the photoluminescent material on a side of the transparent substrate (100) where the at least one solar cell (200) is disposed.

14. The method according to claim 13, wherein before the at least one solar cell (200) is placed on the transparent substrate (100), a transparent bonding layer (400) is applied to the transparent substrate (100) to preliminarily secure the at least one solar cell (200) subsequently placed, wherein the transparent bonding layer (400) has a thickness of 200 micrometers or less.

15. The method according to any one of claims 11 to 14, wherein after the photoluminescent material and the at least one solar cell (200) are disposed on the transparent substrate (100), the transparent gel is cured to form the photoluminescent layer (300).
